## Europäisches Patentamt
## European Patent Office
## Office européen des brevets

(19)

(11) Publication number: **0 313 619 B1**

# EUROPEAN PATENT SPECIFICATION

(12)

(45) Date of publication of patent specification :
**01.07.92 Bulletin 92/27**

(51) Int. Cl.⁵ : **C30B 15/00, C30B 29/66, C30B 15/28, C30B 15/34**

(21) Application number : **88904166.1**

(22) Date of filing : **22.04.88**

(86) International application number :
**PCT/US88/01353**

(87) International publication number :
**WO 88/08786 17.11.88 Gazette 88/25**

(54) **SYSTEM FOR CONTROLLING APPARATUS FOR GROWING TUBULAR CRYSTALLINE BODIES.**

(30) Priority : **05.05.87 US 46991**

(43) Date of publication of application :
**03.05.89 Bulletin 89/18**

(45) Publication of the grant of the patent :
**01.07.92 Bulletin 92/27**

(84) Designated Contracting States :
**BE CH FR IT LI NL SE**

(56) References cited :
**US-A- 3 934 983**
**US-A- 4 318 769**
**US-A- 4 544 528**

(56) References cited :
**JOURNAL OF CRYSTAL GROWTH, PROC. OF THE 1ST INT. SYMP. ON SHAPED CRYSTAL GROWTH, 22nd-25th July 1986, Budapest, vol. 82, no.1,2, 1st March 1987, pages 134-141, Elsevier Science Publishers B.V., (North-Holland Physics Publishing Division), Amsterdam, NL;A.S. TAYLOR et al.: "Long nonagons - an approach to high productivity silicon sheet using the EFG method"**

(73) Proprietor : **MOBIL SOLAR ENERGY CORPORATION**
**Middlesex Technology Center 4 Suburban Park Drive**
**Billerica, MA 01821 (US)**

(72) Inventor : **MACKINTOSH, Brian, H.**
**31 Sherman Street**
**Lexington, MA 02173 (US)**

(74) Representative : **Kerr, Simonne June et al**
**European Patent Attorney POTTS, KERR & CO. P.O. Box 688**
**Ascot Berkshire SL5 8YT (GB)**

EP 0 313 619 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

## Background of the Invention

## Field of the Invention

This invention pertains to apparatus for growing crystals, and more particularly to control systems for controlling apparatus for growing tubular crystalline bodies.

## Prior Art

Silicon sheet used in the fabrication of semiconductor devices is frequently formed from the flat sides of tubular crystalline bodies of the type having a plurality of sides, e.g. a nonagon crystal. Apparatus of the type described in U.S. Patent No. 4544528 have been used to manufacture these crystalline bodies according to the edge-defined, film-fed growth process (the EFG process). Briefly, these apparatus comprise a crucible for containing a melt of the material to be grown (e.g., silicon), a capillary die for controlling the form and shape of the grown crystal, a heater for controlling the temperature of the die and melt, a seed support assembly for supporting the seed used in growing the crystal, and a pulling mechanism coupled to the seed support assembly for drawing the tubular crystalline body out of the melt.

To produce a commercially-satisfactory silicon substrate and to ensure the crystal growth process is not prematurely terminated by either detachment or by freeze-up of the tubular crystalline body, it is essential that crystal wall thickness of the growing body be closely controlled. In capillary die apparatus of the type disclosed in U.S. Patent No. 4544528, it is well known that wall thickness of the growing crystalline body varies with the size and shape of the meniscus formed between the top of the die and the bottom of the growing body. Using this relationship between wall thickness and various geometric characteristics of the meniscus, a variety of devices incorporating optical systems, such as those disclosed in U.S. Patents Nos. 4239583, 4267151 and 4318769, have been developed for controlling the operation of crystal-growing apparatus. These optics-based systems comprise an optical assembly for viewing the meniscus. Using information regarding the configuration of the meniscus obtained via the optical assembly, an operator adjusts the operation of the crystal-growing apparatus so as to produce a crystalline body having the desired wall thickness.

Although satisfactory wall thickness control may be achieved with the foregoing optical control systems, certain limitations exist with respect to the use of these systems. First, an operator must continuously monitor the configuration of the meniscus and adjust the operation of the crystal growing apparatus based on what he or she observes. To avoid human error, increase crystal growth rates, and reduce the costs associated with the use of a technician, it is desirable to automate the entire crystal growth operation. Second, with known optical control systems only a relatively small portion of the entire meniscus is observable. The configuration of this small portion is not necessarily representative of the configuration of the entire meniscus.

With known crystal growing apparatus of the type illustrated in U.S. Patent No. 4544528, it has been difficult and impractical to grow crystalline bodies having a length greater than about 2 meters. This difficulty is caused, in part, by the necessity to exclude air from the interior of the growing tubular crystal body by filling the latter with an inert gas such as argon, and, in part, by the fact that convection currents are generated within this volume by large temperature differences existing therein.

More specifically, an inert gas, typically argon, is injected into the interior of the growing crystalline body so as to exclude ambient air from the interior of the body. Because inert gas is heavier than ambient air, in a crystalline body having a length greater than about 2 meters, the inert gas column inside the body attains sufficient length, and hence sufficient weight, so that the column tends to sink, thereby permitting ambient air to be drawn into the body through the top end thereof.

When measures are taken to prevent ambient air from entering the crystalline body, such as by capping the top end of the body, the deleterious effects of the convection currents generated within the body increase significantly. When the tube is capped, these convection currents cause pressure fluctuations within the crystalline body which make it difficult to control the operation of the crystal growing apparatus. As a result, growth of crystalline bodies having a uniform wall thickness and lengths greater than about 2 meters is problematic.

A significant portion of the total time required to grow a crystalline body is consumed in preparing the crystal growing apparatus for the growth procedure. Consequently, to improve process efficiency it is desirable to grow crystals having lengths greater than about 2 meters.

In J. Cryst. growth 82/1-2 (March 1987) pages 134 to 141, an apparatus and method for the control of wall thickness during the growth of nonagous of silicon are disclosed, which are based on the measurement of the neight and the length of the crystal to be grown. Influence on the process control is, however, reported due to air leakages.

An object of the present invention is to overcome the foregoing disadvantages associated with known systems for controlling the operation of apparatus for growing tubular crystals.

According to the present invention an apparatus for controlling the operation of a device for growing a tubular crystalline body comprises a crucible for containing a melt, a heater for heating the crucible, growing means for growing a tubular crystalline body from the melt, the growing means comprising a seed holder for supporting a seed on to which the crystalline body is grown and pulling mechanism for pulling the tubular crystalline body and the seed holder away from the crucible, characterized in that the seed holder is constructed so as to substantially pneumatically block an upper end of the tubular crystalline body, and in that the apparatus comprises a length sensor for generating an output signal that is representative of the length of the growing tubular crystalline body, a weight sensor for generating an output signal that is representative of the weight of the growing tubular crystalline body, the seed and the seed holder, a controller coupled to the length sensor and the weight sensor and adaptor for coupling to the heater, for controlling the operation of the device responsive to the output signals of the length sensor and the weight sensor, a pressure sensor for generating an output signal that is representative of the pressure inside the growing tubular crystalline body and the controller is adapted to control the operation of the device responsive to the output signals of the length sensor, the weight sensor and the pressure sensor so as to ensure that the growing tubular crystalline body has a substantially uniform wall thickness.

Also according to the invention, a method for controlling the operation of a device for growing a tubular crystalline body with a substantially uniform wall thickness is provided in which the device includes a crucible for containing a melt, a heater for heating the crucible and growing means for growing a tubular crystalline body from the melt, the growing means comprising a seed holder for supporting a seed onto which the crystalline body is grown and a pulling mechanism for pulling the tubular crystalline body, the seed, and the seed holder away from the crucible, the seed holder being constructed so as to substantially pneumatically block an upper end of the tubular crystalline body, said method being characterized by monitoring the length of the growing tubular crystalline body and producing a first signal that is representative of said length, generating a second signal that is representative of the weight of the growing tubular crystalline body, sensing the fluid pressure within the growing tubular crystalline body and producing a third signal that is representative of said fluid pressure, and using said first, second and third signals to control operation of the device so that the tubular crystalline body will grow with a substantially uniform wall thickness.

The invention will now be described further, by way of example, with reference to the accompanying drawings, in which: -

Fig. 1 is a schematic illustration, partly in section, of the preferred embodiment of the present invention;

Fig. 2 is a chart that graphically illustrates the output, over time, of the pressure sensor and the weight sensor of the present invention relative to the true weight of the crystal; weight of the crystal;

Fig. 3 is a circuit diagram of the true weight circuit employed in the preferred embodiment of the present invention; and

Fig. 4 is a software flow diagram illustrating the various operations performed by the control system of the present invention in controlling the operation of a crystal growing apparatus.

Detailed Description of the Invention

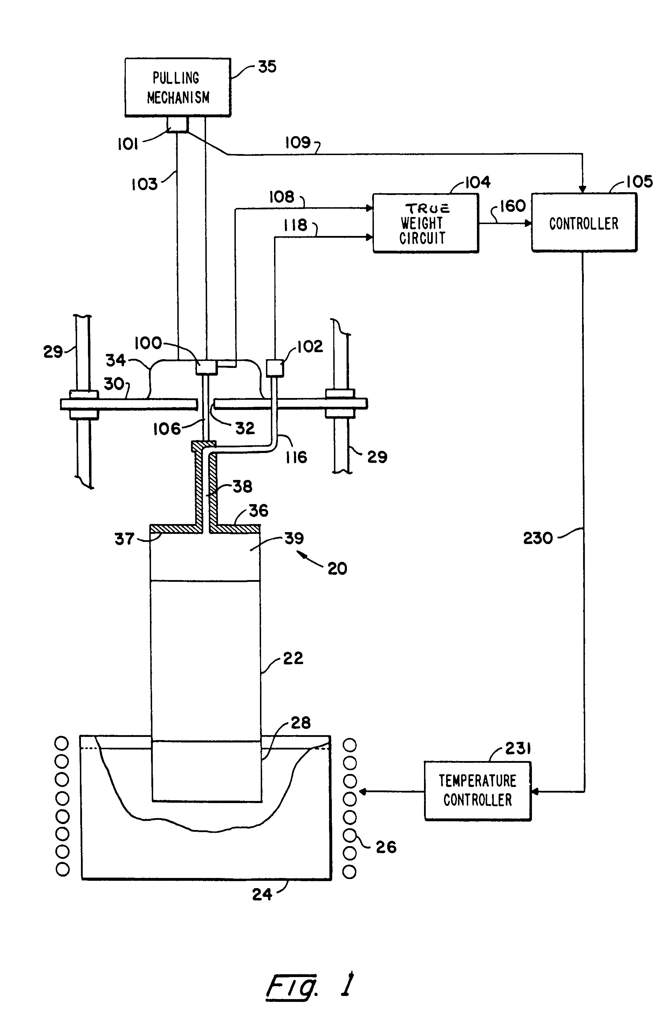

Referring to Fig. 1, the present invention comprises a control system for controlling the operation of an apparatus 20 for growing tubular crystalline bodies 22 of semiconductor materials. Although not shown in detail, it is to be understood that apparatus 20 comprises a furnace of the type described and illustrated in U.S. Patent Nos. 4544528, 4239583, 4267151 and 4318769. More specifically, apparatus 20 comprises a crucible 24 for containing a melt of the semiconductor material to be crystallized, a heater 26 for heating the melt, and a capillary die 28 of desired shape for forming the body 22. The capillary die may take various forms, but preferably it is in the form shown in Fig. 1 of the U.S. Patent No. 4544528, except that it is shaped to grow a body of round or selected polygonal shape, e.g. a nonagon or an octagon. A pair of fixed parallel rails 29 and a frame 30 mounted for slidable movement thereon are provided for use in drawing a crystalline body 22 out of the melt. An aperture 32 (see drawing) is provided in frame 30 and an attachment plate 34 is secured to the frame adjacent the aperture. A gulling mechanism 35, of the type well known in the art, is supported above crucible 24 at a fixed location axially distal thereto and is coupled to frame 30 for pulling the latter along rails 29 and away from crucible 24 at a substantially constant rate of speed. Connected to frame 30 is seed holder 36. The latter is mechanically coupled to a seed crystal 39 (Fig. 1) from which crystalline body 22 is grown.

The foregoing brief description of apparatus 20 is sufficient for understanding the interrelationship between the control system of the present invention and the apparatus it controls. For a more detailed description of an exemplary one of apparatus 20, attention is directed to the aforementioned U.S. Patent No. 4544528 issued to Stormont et al, which is incorporated herein by reference.

A preferred embodiment of the control system of the present invention comprises weight sensor 100, length sensor 101, pressure sensor 102, true weight circuit 104, and controller 105. In the preferred embodiment, seed holder 36 is constructed so as to substantially pneumatically block the upper end of the body so as to limit the quantity of fluid that can escape from the inside of the body through the upper end thereof. Seed holder 36 comprises a surface 37 that extends normally to the axis of tubular crystal 22 and a conduit 38 that fluidly couples the interior of crystal 22 with the exterior of the seed holder.

Weight sensor 100 is fixed to attachment plate 34 and is coupled to seed holder 36 by an axially extendible rod 106. The latter extends through aperture 32 in frame 30. Weight sensor 100 measures the weight of crystalline body 22 and seed holder 36, including seed 39. The output of weight sensor 100 is carried on line 108 to true weight circuit 104. Weight sensor 100 is a conventional strain gauge load cell.

Length sensor 101 is provided for measuring the displacement of frame 30 relative to fixed crucible 24. Length sensor 101 is attached to a fixed object, preferably to pulling mechanism 35, positioned above crucible 24. Length sensor 101 comprises a conventional drum and cable length measuring transducer. As pulling mechanism 35 pulls frame 30 along rails 29, cable 103 is wound around the drum. The amount of cable wound onto the drum corresponds to the length of the crystal and is measured by a potentiometer contained in the drum. The output of the potentiometer of length sensor 101 is carried on line 109 to controller 105.

Pressure sensor 102 is provided for measuring the pressure inside crystalline body 22 acting upwardly against seed holder surface 37. Pressure sensor 102 is fluidly coupled to conduit 38 and hence to the interior of body 22 by a tube 116. Pressure sensor 102 may be mounted to attachment plate 34 or to any other suitable element. The output of pressure sensor 102 in transmitted on line 118 to true weight circuit 104. Pressure sensor 102 is a capacitive-type sensor.

Referring now to Figs. 1-3, true weight circuit 104 is provided for continuously generating a signal that is representative of the true weight of growing crystalline body 22 at any selected interval during the crystal growth process. Briefly, true weight circuit 104 combines the outputs of weight sensor 100 and pressure sensor 102 to generate a signal that is representative of the true weight of growing crystalline silicon body 22, seed holder 36, and seed 39. An offset voltage signal is then subtracted from the true weight signal to provide a signal that is representative of the true weight of only the growing crystalline body 22.

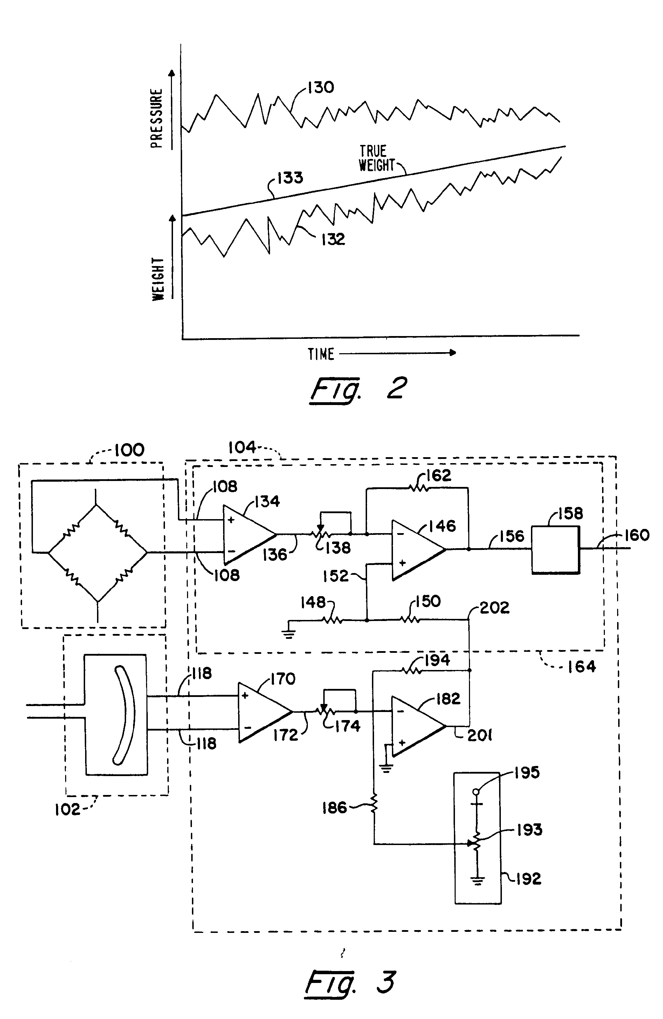

However, the true weight of growing body 22 cannot be measured directly by weight sensor 100 due to pressure forces generated within the body that act upwardly against seed holder surface 37. When the force acting on surface 37 increases, the growing crystalline body 22 is lifted against the pull of gravity, causing the output signal of weight sensor 100, which is representative of the weight of crystal body 22, to decrease, as illustrated by the downward spikes in line 132 in Fig. 2. Likewise, when the force acting on surface 37 decreases, weight sensor 100 detects an increase in the weight of crystal body 22, as illustrated by the upward spikes in line 132 in Fig. 2. These variations in the output signal of weight sensor 100 reduce the accuracy of the control information generated by controller 105. The pressure fluctuations inside crystal body 22 measured by pressure sensor 102 vary in direct inverse relationship with the weight measurements made by weight sensor 100. By summing together the pressure and weight signals, as described in greater detail below, the true weight of crystalline body 22, illustrated by line 133 in Fig. 2, can be established. True weight circuit 104 is provided for generating this true representation of the weight.

By constructing seed holder 36 so that the latter and seed 39 substantially completely block off the end of crystal body 22, as noted above, the magnitude of the pressure fluctuations inside the body is greatly increased, as compared to the fluctuations that occur inside an unsealed crystal of the type grown with the apparatus disclosed in the aforementioned U.S. Patent Application 4544528. The errors in weight measurement that are consequent to these pressure fluctuations motivate the use of pressure sensor 102 and the true weight circuit 104.

Describing true weight circuit 104 shown in Fig. 3 in detail, the output of weight sensor 100 is connected via lines 108 to a amplifier 134. Amplifier 134 is connected by line 136 to weight calibration potentiometer 138. The latter is connected to the negative junction of summing amplifier 146. One terminal of a resistor 148 is connected by line 152 to the positive input junction of amplifier 146 and the other terminal of resistor 148 is connected to ground. One terminal of a resistor 150 is also connected via line 152 to the positive junction of amplifier 186. The other terminal of resistor 150 is connected to another portion of the weight circuit 104, an described below. The output of amplifier 146 is connected over line 156 to a filter 158, and the output of the latter is supplied over line 160 to controller 105. A resistor 162 in connected between output line 156 and the negative input terminal of amplifier 146 in the conventional configuration for summing amplifiers.

The foregoing elements 134-162, inclusive, provide signal conditioning of the output of weight sensor 100, as is well known in the art. Weight calibration potentiometer 138 is used to calibrate the output of true weight circuit 104 to accommodate variation in sensitivity of weight sensor 100.

The output of pressure sensor 102 is supplied on lines 118 to amplifier 170. The latter is connected on line 172 to pressure calibration potentiometer 174, which potentiometer is connected to the negative input junction of summing amplifier 182. The positive junction of amplifier 182 is connected to ground. Offset voltage source 192 is connected by resistor 186 to the negative input junction of summing amplifier 182. Offset voltage source 192 comprises a conventional potentionmeter 193 and a suitable potential 195. A resistor 194 connects resistor 186 to the positive input terminal of amplifier 146, via resistor 150, in the conventional configuration for summing amplifiers. The polarity of the output signal of offset voltage source 192 is selected such that when the former signal is added to the output signal of weight sensor 100, through amplifier 182 and associated resistors 186, 194 and 150, the magnitude of the latter signal is reduced, as described in greater detail hereinafter. The output of amplifier 182 on line 201 is connected via line 202 to one terminal of resistor 150. As noted above, the other terminal of resistor 150 is connected via line 152 to the positive junction of amplifier 146.

An offset signal derived from voltage source 192 is combined with the output signal of pressure sensor 102 and the resultant signal is amplified by amplifier 182. The output signal of amplifier 182 is summed with the output signal of weight sensor 100 at summing amplifier 146. Weight calibration potentiometer 138 and pressure calibration potentiometer 174 are adjusted to scale the output signals of the weight sensor 100 and pressure sensor 102 respectively, so that at any point in time, the magnitude of the pressure signal on line 172 is equal and opposite to the portion of the weight signal on line 136 resulting from the pressure acting on seed holder surface 37. For instance, at a selected measurement interval, the output signal of weight sensor 100, as scaled by amplifier 134 and potentiometer 138, may be +1.5v., and the output signal of pressure sensor 102, as scaled by amplifiers 170 and 182, and the associated resistances, may be -0.5v. By adding the outputs of weight sensor 100 and pressure sensor 102 at amplifier 146, a summation of the output signals is obtained, i.e. +1.0v., which is representative of the true weight of crystalline body 22, seed 39, and seed holder 36 at the selected measurement interval.

The output signal of offset voltage source 192, amplified through amplifier 182, results in an additionaly constant signal which, when applied to amplifier 146, reduces the output of the latter by an amount corresponding to the weight of seed 39 and seed holder 36. As a consequence, the output signal of amplifier 146 represents the true weight of crystalline body 22.

The true weight signal on line 156 is finally processed through filter circuit 158, to attenuate undesirable components resulting from mechanical vibrations and electrical noise generated within the weight sensor. This signal is then conducted to controller 105 via line 160.

Controller 105 is provided for controlling the operation of crystal growing apparatus 20. In the preferred embodiment of the invention, pulling mechanism 35 is operated to draw crystalline body 22 out of crucible 24 at a constant rate of speed. Thus, operation of apparatus 20 may be controlled solely by adjusting the output of crucible heater 26. Controller 105 provides the temperature control signal used to effect this adjustment of crucible heater 26. Controller 105 may take one of a variety of forms including, for instance, an industrial process digital minicomputer.

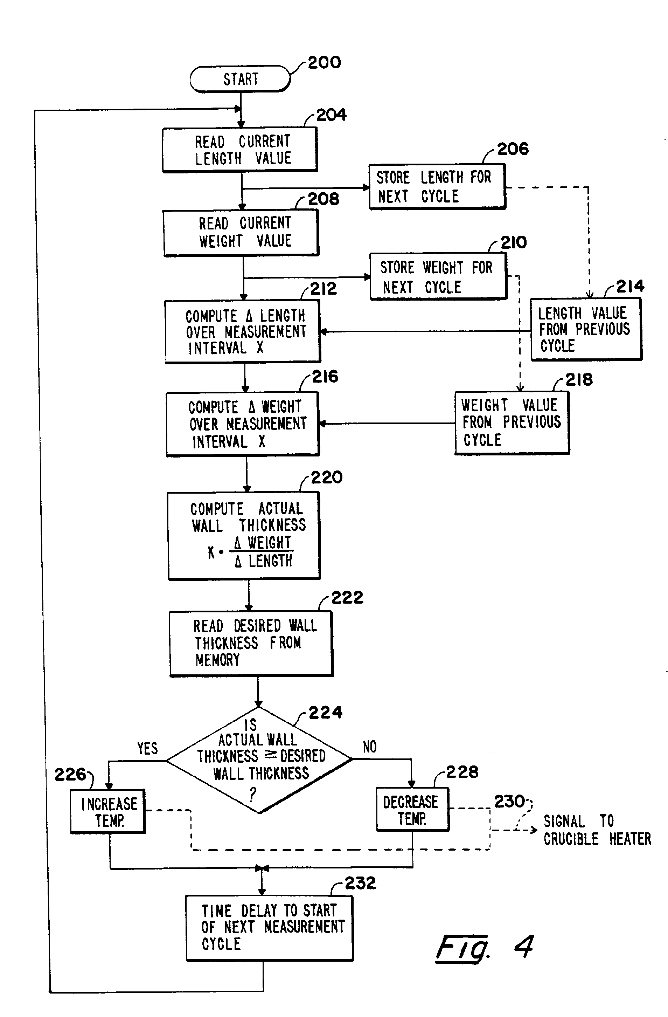

Turning now to Figs. 1 and 4, controller 105, using input signal information provided thereto, controls the operation of crucible heater 26 in accordance with a machine control software program. The software flow diagram illustrated in Fig. 4 provides a logical outline of the operations performed by the software program. Line by line coding of the software program is not illustrated or described herein, as such coding is considered to be well within the skill of an ordinary practitioner.

As the first step in the flow diagram, the control system of the present invention is actuated so as to begin controlling the operation of apparatus 20, as illustrated by step 200. Next, controller 105 reads in the current length of crystalline body 22, as illustrated by step 204. Length transducer 101 provides this current length information over line 109 to controller 105. Next, at step 206, the current length information is stored for the next cycle. Thereafter, controller 105 reads in the current weight of crystalline body, as illustrated at step 208. This current weight information is generated by true weight circuit 104 and is provided to controller 105 over line 160. Next, at step 210, the current weight information is stored for the next cycle.

Thereafter, the change in length of crystalline body 22 over measurement interval X is computed, as illustrated by step 212. This derivation is performed using current length data and length data from the previous measurement cycle. Current length data is supplied directly from length transducer 101 and previous cycle length data is read in, as illustrated by step 214, using the data stored at step 206. Clearly, during the first iteration of the flow diagram the length derivation information generated will be nonsensical because no previous cycle length data will have been generated. Measurement interval X preferably ranges between about 30 seconds and 3 minutes. Measurement interval X can be stored in controller 105 as a fixed setpoint or the interval can be entered as a control variable at the beginning of a crystal-growing operation.

Next, the change in weight of crystalline body 22 over the measurement interval X is computed, as illustrated by step 216. This derivation is performed using current weight data and weight data from the previous measurement cycle. Current weight data is supplied directly from true weight circuit 104 and previous cycle weight data in read in, as illustrated by step 218, using the data stored at step 210. As with step 212, weight derivation information generated during the first iteration will be nonsensical. Measurement interval X used in step 216 is identical to measurement interval X used in step 212, i.e., X preferably ranges from about 30 seconds to 3 minutes.

Then, at step 220, the actual wall thickness of crystalline body 22 is calculated by multiplying a constant, K, by the change in weight of the crystalline body calculated in step 216 and then dividing this product by the change in length of body 22 calculated in step 212. As one skilled in the art will recognize, K is a wall thickness conversion constant that is selected on the basis of the desired wall thickness of the crystalline body to be grown and the magnitude of the output signal of length sensor 100 and true weight circuit 104.

Next, desired wall thickness information is read from memory, as illustrated by step 222. Thereafter, at step 224, the actual wall thickness calculated at step 220 is compared to the desired wall thickness read in at step 222 to determine if the actual wall thickness is greater than or equal to the desired wall thickness. If the actual wall thickness is greater than or equal to the desired wall thickness, the flow diagram proceeds to step 226, whereat controller 105 generates a temperature increase signal that is supplied on line 230 to crucible heater 26. Upon receipt of this increase signal, crucible heater 26 will operate so as to elevate the temperature of the melt, which in turn will cause the wall thickness of the crystalline body 22 to decrease. If the actual wall thickness is not greater than or equal to the desired wall thickness, the flow diagram proceeds to step 228, whereat controller generates a temperature decrease signal that is supplied on line 230 to crucible heater 26. Upon receipt of this decrease signal, crucible heater 26 will operate so as to allow the temperature of the melt to decrease which, in turn, will cause the wall thickness of the crystalline body 22 to increase. In practice, because the wall thickness of crystal body 22 tends to decrease as the length of the body increases, the temperature of die 28 is typically decreased as the crystal grows longer by decreasing the output of crucible heater 26.

The nature of the signal provided by controller 105 and the manner in which crucible heater 26 processes the signal provided by the controller so as to adjust the temperature of the die and melt is immaterial to the present invention. Nevertheless, crucible heater 26 may, for instance, comprise a stepping heater, the output of which is adjustable stepwise. Thus, upon receipt of a positive signal from controller 105 the thermal output of heater 26 will increase by an amount Y, and upon receipt of a negative signal from controller 105 of output of heater 26 will decrease by an amount Y. Optionally, a conventional temperature controller 231 may be coupled between crucible heater 26 and output line 230, as illustrated in Fig. 1.

Based on the output signal on line 230 from controller 105, the temperature controller 231 varies the power input to crucible heater 26 so as to ensure a crystalline body 22 having a substantially uniform wall thickness is grown.

At the final step 232, a time delay is introduced before the next current length and weight values are read in. Because steps 204-228 are typically performed in less time than exists in a measurement interval, step 232 is provided to allow the remaining time in a measurement interval to run out before the next length and weight values are read in.

At the end of the time delay, the foregoing steps of the software flow diagram are repeated beginning with step 204.

The present invention is adapted to control the operation of known crystal growing apparatus with greater accuracy than is typically obtainable with known control systems. By controlling accurately the operation of known crystal growing apparatus, several important advantages are achieved. First, the frequency with which a growing crystalline body 22 will detach from, or freeze to, the die is greatly reduced. Second, the wall thickness of the tubular crystalline body is more accurately controlled. Third, crystal bodies 22 having lengths of up to 6 meters or more can be grown with relatively constant wall thickness using known crystal growing apparatus controlled by the present invention and modified so as to substantially pneumatically seal the top end of the crystal being grown. Material costs for silicon sheet produced from long crystalline bodies, e.g. bodies 6 meters long, are significantly less than for sheet produced from the relatively short crystalline bodies that are grown with known crystal growing apparatus, due to the avoidance of losses due to freezeups and detachment, and due to the reduction in apparatus start-up time relative to the length of crystal grown.

Although the present invention is designed to control the operation of EFG crystal growing furnace apparatus of the type disclosed in the aforementioned U.S. Patent No. 4544528, it is to be appreciated that the present invention may be adapted to control the operation of other furnace apparatus for growing hollow crystalline bodies.

While the invention is preferably designed to vary the heating rate of the crucible so as to control wall thickness (the pulling speed being held substantially constant), the invention may be designed so that the heating rate is held constant and the pulling speed is varied so as to control wall thickness. Alternatively, both the heating rate and pulling speed may be varied so as to produce a crystal having a substantially uniform wall thickness.

**Claims**

1. An apparatus (20) for controlling the operation of a device for growing a tubular crystalline body (22), the device comprising a crucible (24) for containing a melt, a heater (26) for heating the crucible (24), growing means for growing a tubular crystalline body from the melt, the growing means comprising a seed holder (36) for supporting a seed on to which the crystalline body is grown and pulling mechanism (35) for pulling the tubular crystalline body (22) and the seed holder (36) away from the crucible (24), characterized in that the seed holder (36) is constructed so as to substantially pneumatically block an upper end of the tubular crystalline body, and in that the apparatus comprises a length sensor (101) for generating an output signal that is representative of the length of the growing tubular crystalline body, a weight sensor (100) for generating an ouput signal that is representative of the weight of the growing tubular crystalline body (22), the seed (39) and the seed holder (36), a controller (105) coupled to the length sensor (101) and the weight sensor (100) and adapted for coupling to the heater (26), for controlling the operation of the device responsive to the output signals of the length sensor (101) and the weight sensor (100), a pressure sensor (102) generating an output signal that is representative of the pressure inside the growing tubular crystalline body (22) and the controller (105) is adapted to control the operation of the device responsive to the output signals of the length sensor (101), the weight sensor (100) and the pressure sensor (102) so as to ensure that the growing tubular crystalline body has a substantially uniform wall thickness.

2. An apparatus according to claim 1, characterized in that the controller (105) is adapted to control the operation of the heater (26).

3. An apparatus according to claim 1 or 2, characterized in that the controller (105) comprises means for calculating the true weight of the tubular crystalline body and for generating a corrected output signal that is representative of the true weight of the tubular crystalline body, the controller being adapted to control the operation of the crucible heater responsive to the output signals of the length sensor and the calculation means.

4. An apparatus according to claim 3, characterized in that the calculating means comprises means for combining the output signals of the weight sensor (100) and the pressure sensor (102) so as to generate a resultant signal that is representative of the true weight of the tubular crystalline body (22) and the seed holder (36) means for generating an offset output signal that is representative of the true weight of the seed holder (36) and means for combining the resultant signal and the offset output signal so as to generate the corrected ouput signal that is representative of the true weight of the tubular crystalline body.

5. An apparatus according to claim 1 or 2, characterized in that the controller comprises means for calculating the actual wall thickness of the tubular crystalline body (22) at any selected measurement interval.

6. An apparatus according to claim 5, characterized in that the controller comprises means for providing a desired wall thickness value and means for comparing the desired wall thickness value with the actual wall thickness and for applying a first signal to the heater (26) when the desired wall thickness value is less than the actual wall thickness and a second signal to the heater (26) when the desired wall thickness value is greater than or equal to the actual wall thickness.

7. An apparatus according to any of claims 1 to 6, characterized in that the pressure sensor (102) is adapted to measure pressure forces inside the tubular crystalline body acting upwardly on the seed holder (36).

8. An apparatus according to any of claims 1 to 7, characterized in that the controller is adapted to control the operation of the crucible heater (26) so as to permit the tubular crystalline body (22) to be grown to a length of 6 meters or more.

9. An apparatus according to any of claims 1 to 8, characterized in that the pulling mechanism (35) is operable to pull the tubular crystalline body (22), the seed (39) and the seed holder (36) away from the melt at a substantially uniform rate of speed.

10. A method for controlling the operation of a device for growing a tubular crystalline body with a substantially uniform wall thickness, the device including a crucible for containing a melt, a heater for heating the crucible and growing means for growing a tubular crystalline body from the melt, the growing means comprising a seed holder for supporting a seed onto which the crystalline body is grown and a pulling mechanism for pulling the tubular crystalline body, the seed, and the seed holder away from the crucible, the seed holder being constructed so as to substantially pneumatically, an upper end of the tubular crystalline body, said method being characterized by monitoring the length of the growing tubular crystalline body and producing a first signal that is representative of said length, generating a second signal that is representative of the weight of the growing tubular crystalline body, sensing the fluid pressure within the growing tubular crystalline body and producing a third signal that is representative of said fluid pressure, and using said first, second and third signals to control operation of the device so that the tubular crystalline body will grow with a substantially uniform wall thickness.

11. A method according to claim 10, characterized in that the first, second and third signals are used to control operation of the heater.

12. A method according to claim 10 or 11, characterized in that the current length of the tubular crystalline body is measured and a change in length value is provided that is representative of the change in length of the tubular crystalline body over a measurement time interval X, the current weight of the tubular crystalline body is measured and a change in weight value is provided that is representative of the change in weight of the tubular crystalline body over the measurement interval X, the current pressure within the growing tubular crystalline body is measured and a change in pressure value is provided that is representative of the change in pressure inside the growing tubular crystalline body over the measurement time interval X, an actual wall thickness value that is representative of the actual wall thickness of the tubular crystalline body is computed and provided using the change in length value, the change in weight value, the change in pressure value and a scaling factor constant K, the actual wall thickness value is compared with a desired wall thickness value and the temperature of the heater is increased if the actual wall thickness value is greater than the desired wall thickness value and the temperature of the heater is decreased if the actual wall thickness value is less than the desired wall thickness value.

13. A method according to claim 12, characterized in that the computing step includes the step of calculating a true weight value that is representative of the true weight of the crystalline body using the change in weight value and the change in pressure value.

**Patentansprüche**

1. Vorrichtung (20) zur Regelung des Betriebs einer Einrichtung zum Aufwachsen eines rohrförmigen kristallinen Körpers (22), mit einem Tiegel (24) zur Aufnahme einer Schmelze, einer Heizung (26) zum Heizen des Tiegels (24), und mit Aufwachsmitteln zum Aufwachsen eines rohrförmigen kristallinen Körpers aus der Schmelze, welche einen Keimkristallhalter (36) zur Aufnahme eines Keimkristalls, an welchem der Kristallkörper wächst, sowie einen Abzugsmechanismus (35) zum Ziehen des rohrförmigen Kristallkörpers (22) und des Keimkristallhalters vom Tiegel (24) weg aufweisen, dadurch gekennzeichnet, dass der Keimkristallhalter so ausgebildet ist, dass er im wesentlichen pneumatisch ein oberes Ende des rohrförmigen Kristallkörpers blockiert, und dass die Vorrichtung weiterhin einen Längenfühler (101) zur Erzeugung eines Ausgangssignals aufweist, welches die Länge des wachsenden rohrförmigen Kristallkörpers wiedergibt, einen Gewichtsfühler (100) zur Erzeugung eines das Gewicht des wachsenden rohrförmigen Kristallkörpers (22), des Keimkristalls (39) und des Keimkristallhalters (36) wiedergebenden Ausgangssignals, ein Steuergerät (105), das mit dem Längenfühler (101) und dem Gewichtsfühler (100) gekoppelt und zum Anschluss an die Heizung (26) eingerichtet ist und den Betrieb der Vorrichtung in Abhängigkeit von den Ausgangssignalen des Längenfühlers (101) und des Gewichtsfühlers (100) steuert, und einen Druckfühler (102) zur Erzeugung eines den Druck im Inneren des wachsenden rohrförmigen Kristallkörpers (22) wiedergebenden Ausgangssignals, und dass das Steuergerät (105) zur Steuerung des Betriebs der Vorrichtung in Abhängigkeit von den Ausgangssignalen des Längenfühlers (101), des Gewichtsfühlers (100) und des Druckfühlers (102) derart eingerichtet ist, dass der wachsende rohrförmige Kristallkörper eine praktisch gleichförmige Wanddicke aufweist.

2. Vorrichtung nach Anspruch 1, dadurch gekennzeichnet, dass das Steuergerät (105) zur Steuerung des Betriebes der Heizung (26) eingerichtet ist.

3. Vorrichtung nach Anspruch 1 oder 2, dadurch gekennzeichnet, dass das Steuergerät (105) Mittel zur Berechnung des wahren Gewichtes des rohrförmigen Kristallkörpers und zur Erzeugung eines korrigierten Ausgangssignals aufweist, das das wahre Gewicht des rohrförmigen Kristallkörpers wiedergibt, und dass das Steuergerät zur Steuerung des Betriebs der Tiegelheizung in Abhängigkeit von den Ausgangssignalen des Längenfühlers und der Berechnungsmittel eingerichtet ist.

4. Vorrichtung nach Anspruch 3, dadurch gekennzeichnet, dass die Berechnungsmittel folgende Mittel aufweisen: Mittel zur Kombination der Ausgangssignale des Gewichtsfühlers (100) und des Druckfühlers (102) zur Erzeugung eines Resultantsignals, das das wahre Gewicht des rohrförmigen Kristallkörpers (22) und des Keimkristallhalters (36) wiedergibt; Mittel zur Erzeugung eines Ausgleichs-Ausgangssignals, das das wahre Gewicht des Keimkristallhalters (36) wiedergibt; und Mittel zur Kombinierung des Resultantsignals und des Ausgleichs-Ausgangssignals zur Erzeugung des korrigierten Ausgangssignals, welches das wahre Gewicht des rohrförmigen Kristallkörpers wiedergibt.

5. Vorrichtung nach Anspruch 1 oder 2, dadurch gekennzeichnet, dass das Steuergerät Mittel zur Berechnung der jeweiligen Wandstärke des rohrförmigen Kristallkörpers bei jedem gewählten Messintervall aufweist.

6. Vorrichtung nach Anspruch 5, dadurch gekennzeichnet, dass das Steuergerät Mittel zur Erzeugung eines Wertes der gewünschten Wandstärke und Mittel zum Vergleich dieses Wertes mit der tatsächlichen Wandstärke aufweist, sowie Mittel zur Übermittlung eines ersten Signals an die Heizung (26), wenn der Werte der gewünschten Wandstärke kleiner ist als die tatsächliche Wandstärke, und eines zweiten Signals an die Heizung (26), wenn der Wert der gewünschten Wandstärke grösser oder gleich der tatsächlichen Wandstärke ist.

7. Vorrichtung nach einem der Ansprüche 1 bis 6, dadurch gekennzeichnet, dass der Druckfühler (102) zur Messung von Druckkräften im Inneren des rohrförmigen Kristallkörpers eingerichtet ist, welche nach oben auf den Keimkristallhalter (36) wirken.

8. Vorrichtung nach einem der Ansprüche 1 bis 7, dadurch gekennzeichnet, dass das Steuergerät zur Steuerung des Betriebs der Tiegelheizung (26) derart eingerichtet ist, dass eine Höhe des rohrförmigen Kristallkörpers (22) von 6 m oder darüber zu erzielen ist.

9. Vorrichtung nach einem der Ansprüche 1 bis 8, dadurch gekennzeichnet, dass der Abzugsmechanismus (35) zum beziehen des rohrförmigen Kristallkörpers (22), des Keimkristalls (39) und des Keimkristallhalters (36) von der Schmelze mit einer praktisch gleichförmigen Geschwindigkeit eingerichtet ist.

10. Verfahren zur Steuerung des Betriebs einer Vorrichtung zum Aufwachsen eines rohrförmigen Kristallkörpers mit im wesentlichen gleichförmiger Wandstärke, wobei die Vorrichtung einen Tiegel zur Aufnahme einer Schmelze, eine Heizung zum Heizen des Tiegels und Mittel zum Aufwachsen eines rohrförmigen Kristallkörpers aus der Schmelze aufweist und letztere Mittel einen Halter zum Halten eines Keimkristalls, an den der Kristallkörper aufwächst, und einen Abzugsmechanismus zum Abziehen des rohrförmigen Kristallkörpers, des Keimkristalls und des Keimkristallhalters vom Tiegel weg aufweisen, wobei der Keimkristallhalter zum praktisch pneumatischen Blockieren eines oberen Endes des rohrförmigen Kristallkörpers eingerichtet ist, dadurch gekennzeichnet, dass die Länge des wachsenden rohrförmigen Kristallkörpers unter Erzeugung eines ersten, diese Länge angebenden Signals überwacht wird, dass ein zweites, das Gewicht des rohrförmigen Kristallkörpers angebenden Signal erzeugt wird, dass der Fluiddruck im Inneren des wachsenden rohrförmigen Kristallkörpers unter Erzeugung eines dritten, diesen Fluiddruck angebenden Signals angefühlt wird, und dass das erste, zweite und dritte Signal zur Steuerung des Betriebs der Vorrichtung derart verarbeitet wird, dass das Wachstum des rohrförmigen Kristallkörpers mit praktisch gleichförmiger Wandstärke erreicht wird.

11. Verfahren nach Anspruch 10, dadurch gekennzeichnet, dass das erste, zweite und dritte Signal zur Steuerung des Betriebs der Heizung verwendet werden.

12. Verfahren nach Anspruch 10 oder 11, dadurch gekennzeichnet, dass das die jeweilige Länge des rohrförmigen Kristallkörpers gemessen und ein Längenänderungswert erzeugt wird, der die Längenänderung des rohrförmigen Kristallkörpers über einem Messzeitintervall X angibt, dass das jeweilige Gewicht des rohrförmigen Kristallkörpers gemessen und ein Gewichtsänderungswert erzeugt wird, der die Gewichtsänderung des rohrförmigen Kristallkörpers im Messzeitintervall X angibt, dass der jeweilige Druck im wachsenden rohrförmigen Kristallkörper gemessen und ein Druckänderungswert erzeugt wird, der die Druckänderung im Inneren des wachsenden rohrförmigen Kristallkörpers im Messzeitintervall X angibt, dass ein Wert der jeweiligen Wandstärke des rohrförmigen Kristallkörpers aus den Werten der Längenänderung, der Gewichtsänderung, der Druckänderung und eines Normierungsfaktors K berechnet wird, dass der Istwert der Wandstärke mit einem Sollwert der Wandstärke verglichen und die Temperatur der Heizung erhöht wird, wenn der Istwert der Wandstärke grösser ist als der Sollwert bzw. die Temperatur der Heizung verringert wird, wenn der Istwert der Wandstärke kleiner ist als deren Sollwert.

13. Verfahren nach Anspruch 12, dadurch gekennzeichnet, dass der Berechnungsschritt eine Berechnung eines Wertes des wahren Gewichts aus der Gewichtsänderung und der Druckänderung enthält, der das wahre Gewicht des Kristallkörpers wiedergibt.

**Revendications**

1. Dispositif (20) pour commander l'opération d'une installation de croissance d'un corps cristallin tubulaire (22), l'installation comprenant un creuset (24) pour recevoir une masse fondue, un chauffage (26) pour chauffer le creuset (24), des moyens pour faire croître un corps cristallin tubulaire à partir de la masse fondue, ces moyens comportant un support de germe (36) pour porter un germe sur lequel le corps cristallin croîtra, et un mécanisme de tirage (35) pour éloigner le corps cristallin tubulaire (22) et le support de germe (36) du creuset (24), caractérisé en ce que le support de germe (36) est construit tel qu'il bloque par voie essentiellement pneumatique un bout supérieur du corps cristallin tubulaire, et en ce que le dispositif comprend un détecteur de longueur (101) pour produire un signal de sortie représentant la longueur du corps cristallin tubulaire (22) en croissance, un détecteur de poids (100) pour produire un signal de sortie représentant le poids du corps cristallin tubulaire (22) en croissance, du germe (39) et du support de germe (36), un organe de commande (105) couplé au détecteur de longueur (101) et au détecteur de poids (100) et adapté à être couplé au chauffage (26), pour commander l'opération du dispositif selon les signaux de sortie des détecteurs de longueur (101) et de poids (100), un détecteur de pression (102) produisant un signal de sortie représentant la pression à l'intérieur du corps cristallin tubulaire (22) en croissance, et que l'organe de commande (105) est adapté pour commander l'opération du dispositif en réponse des signaux de sortie des détecteurs de longueur (101), de poids (100) et de pression (102) afin d'assurer une épaisseur de paroi essentiellement uniforme du corps cristallin tubulaire en croissance.

2. Dispositif selon la revendication 1, caractérisé en ce que l'organe de commande (105) est adapté pour commander l'opération du chauffage (26).

3. Dispositif selon la revendication 1 ou 2, caractérisé en ce que l'organe de commande (105) comporte des moyens pour calculer le poids réel du corps cristallin tubulaire, et pour produire un signal de sortie corrigé représentant le poids réel du corps cristallin tubulaire, l'organe de commande étant adapté pour commander l'opération du chauffage du creuset selon les signaux de sortie du détecteur de longueur et des moyens de calcul.

4. Dispositif selon la revendication 3, caractérisé en ce que les moyens de calcul comprennent des moyens pour combiner les signaux de sortie des détecteurs de poids (100) et de pression (102) pour engendrer un signal résultant, représentant le poids réel du corps cristallin tubulaire (22) et du support de germe (36), des moyens pour produire un signal de compensation représentant le poids réel du support de germe (36), et des moyens pour combiner le signal résultant et le signal de compensation pour produire le signal de sortie corrigé représentant le poids réel du corps cristallin tubulaire.

5. Dispositif selon la revendication 1 ou 2, caractérisé en ce que l'organe de commande comprend des moyens pour calculer l'épaisseur de paroi effective du corps cristallin tubulaire (22) à tout intervalle de mesure choisi.

6. Dispositif selon la revendication 5, caractérisé en ce que l'organe de commande comprend des moyens pour créer une valeur de consigne de l'épaisseur de paroi et des moyens pour comparer la valeur de consigne avec la valeur effective de l'épaisseur de paroi, et pour appliquer un premier signal au chauffage (26) lorsque la valeur de consigne de l'épaisseur de paroi est plus petite que la valeur effective, et un second signal au chauffage (26) lorsque la valeur de consigne de l'épaisseur de paroi dépasse ou égale la valeur effective de l'épaisseur de paroi.

7. Dispositif selon l'une quelconque des revendications 1 à 6, caractérisé en ce que le détecteur de pression (102) est arrangé pour mesurer des forces de pression à l'intérieur du corps cristallin tubulaire qui agissent vers le haut sur le support de germe (36).

8. Dispositif selon l'une quelconque des revendications 1 à 7, caractérisé en ce que l'organe de commande est agencé pour commander l'opération du chauffage (26) du creuset pour permettre la croissance du corps cristallin tubulaire jusqu'à une longueur de 6 mètres ou davantage.

9. Dispositif selon l'une quelconque des revendications 1 à 8, caractérisé en ce que le mécanisme de tirage (35) est agencé pour éloigner le corps cristallin tubulaire (22), le germe (39) et le support de germe (36) de la masse en fusion avec une vitesse essentiellement uniforme.

10. Procédé pour commander l'opération d'une installation de croissance d'un corps cristallin tubulaire avec une épaisseur de paroi essentiellement uniforme, cette installation comprenant un creuset pour contenir une masse fondue, un chauffage pour chauffer le creuset, et des moyens de croissance pour faire croître un corps cristallin tubulaire à partir de la masse fondue, les moyens de croissance comportant un support de germe pour porter un germe sur lequel le corps cristallin croîtra, et un mécanisme de tirage pour éloigner le corps cristallin tubulaire, le germe et le support de germe du creuset, le support de germe étant agencé pour bloquer par voie essentiellement pneumatique une extrémité supérieure du corps cristallin tubulaire, caractérisé en ce que la longueur du corps cristallin tubulaire en croissance est surveillée et un premier signal représentant cette longueur est créé, qu'un second signal représentant le poids du corps cristallin tubulaire croissant est engendré, que la pression de fluide à l'intérieur du corps cristallin tubulaire croissant est détectée et un troisième signal représentant cette pression de fluide est produite, et que les premier, second et troisième signaux sont utilisés pour commander l'opération de l'installation de telle manière que le corps cristallin tubulaire croîtra avec une épaisseur de paroi essentiellement uniforme.

11. Procédé selon la revendication 10, caractérisé en ce que les premier, second et troisième signaux sont utilisés pour commander l'opération du chauffage.

12. Procédé selon la revendication 10 ou 11, caractérisé en ce que la longueur courante du corps cristallin tubulaire est mesurée et qu'une valeur de changement de longueur est produite représentant le changement de longueur du corps cristallin tubulaire pendant un intervalle de temps de mesure X, que le poids courant du corps cristallin tubulaire est mesuré et qu'une valeur de changement de poids, représentant le changement de poids du corps cristallin tubulaire pendant l'intervalle de mesure X, est produite, que la pression courante à l'intérieur du corps cristallin tubulaire croissant est mesurée et qu'une valeur de changement de pression est produite, représentant le changement de pression à l'intérieur du corps cristallin tubulaire croissant au cours de l'intervalle de mesure X, qu'une valeur d'épaisseur de paroi est calculée, représentant l'épaisseur de paroi effective du corps cristallin tubulaire, à partir des changements des valeurs de longueur, de poids et de pression et d'une constante de facteur d'adaptation K, que la valeur de l'épaisseur de paroi effective est comparée à une valeur d'épaisseur de paroi de consigne, que la température du chauffage est augmentée lorsque la valeur d'épaisseur de paroi effective dépasse la valeur de consigne, et que la température du chauffage est baissée lorsque la valeur effective d'épaisseur de paroi est plus petite que la valeur de consigne.

13. Procédé selon la revendication 12, caractérisé en ce que l'étape de calcul comprend une étape de calculer la valeur de poids réel représentant le poids réel du corps cristallin tubulaire en utilisant les valeurs de changements de poids et de pression.

<u>Fig. 1</u>

Fig. 2

Fig. 3

EP 0 313 619 B1

13

_Fig. 4_